# EUROPEAN PATENT APPLICATION

(11) **EP 4 529 391 A1**
(43) Date of publication of application: **26.03.2025**
(21) Application number: 23199478.1
(22) Date of filing: 25.09.2023
(51) Int. Cl.: H10K 30/86

(54) **OPTOELECTRONIC DEVICES COMPRISING METAL OXIDE CHARGE TRANSPORT LAYERS**

(71) Applicant: Avantama AG, 8712 Stäfa (CH)
(72) Inventor: Lüchinger, Norman Albert, 8706 Meilen (CH); Rossier, Michael, 8005 Zürich (CH); Linardi, Flavio, 8620 Wetzikon (CH)
(74) Representative: E. Blum & Co. AG

(57) **Abstract**

The present invention relates to optoelectronic devices comprising a multitude of layers, wherein at least one of said multitude of layers is a charge transport layer comprising metal oxide nanoparticles and a zwitterionic ligand.

## Description

### FIELD OF THE INVENTION

The present invention relates to the technical field of optoelectronic devices comprising metal oxide charge transport layers.

### BACKGROUND OF THE INVENTION

It is known to use charge transport layers, also called buffer layers, in optoelectronic devices, such as light emitting devices (e.g. displays, such as QDs displays) and photoconversion devices (e.g. solar cells, such as perovskite solar cells, organic solar cells, optical sensors), in order to increase the efficiency and life-time of said devices. Such charge transport layers comprise metal oxides, such as zinc-, tin-, titanium-, tungsten-, nickel-, niobium- oxides, corresponding mixed metal oxides or corresponding doped metal oxides, such as Al-doped ZnO ("AZO"), antimony doped SnO₂ ("ATO") or Cu-doped nickel oxide. Generally, such metal oxides in particulate form are known. Typically, the above charge transport layers comprising metal oxides are manufactured by thermal evaporation under high vacuum or by wet-chemical (precursor based) methods, requiring a high temperature annealing step. Both manufacturing methods suffer in terms of cost and large-area manufacturing processing.

It is also known that organic solar cells (OPV) and perovskite solar cells offer a promising approach for a low-cost and flexible photovoltaic technology with certified efficiencies exceeding 10%. Before widespread commercialization, large area production and stability issues have to be solved. For the reliable large area production with high yield and low shunts, thick, stable, robust and printable/coatable buffer/charge transport layers are a prerequisite.

WO 2015/085441 A1 describes an organic electronic device containing a buffer layer. The buffer layer comprises metal oxide nanoparticles coated with at least one dispersant. The dispersant used therein is either a phosphate ester of alkyl ethers of formula (I)

RO-(C₂H₄O)ₘ(C₃H₆O)ₙ-H (I)

wherein R is C₁-C₁₀-alkyl; and m and n are each, independently, 2 to 60
or a phosphate ester of block copolymers of formula (III)

   RO(C₂H₄O)ₒ(RES)ₚ-H (III)

   wherein R is C₁₋₁₀-alkyl; PES is a polyester derived from a cyclic lactone; o is from 5 to 60; p is from 2 to 30; and where the molecular weight of RO(C₂H₄O)ₒ is greater than the molecular weight of (PES)p. A suspension containing the metal oxide nanoparticles, the dispersant and a solvent selected from the group consisting of water, alcohols, glycol ethers and ketones, serves as precursor of the buffer layer. The suspension is applied on a substrate by coating or printing, followed by the removal of the solvent, and optional treatment of the dried layer at elevated temperature.

WO 2016/128133 A1 describes optoelectronic devices comprising a solution-processable metal oxide buffer layer. The buffer layer comprises 70-99.9 wt-% metal oxide nanoparticles. The metal oxide nanoparticles comprise physisorbed metal salts of formula M_{z}^{a+}R_{y}^{b-} in an amount of 1-10 wt%, wherein the molar fraction of metal salt cation to metal atoms/ions in the nanoparticle is 0.02 - 6 mol%. The metal salt cation M is selected from the group consisting of Zn, Al, Y, Pb, Bi Cu, Ni, Co, Fe, Mn, Cr, V, Ti, La, Mg, Ca, Sr and Ba. The buffer layer is manufactured using a suspension containing metal oxide nanoparticles, metal salts and a polar solvent. The manufacturing process includes applying the suspension on a (coated) substrate by coating or printing, followed by the removal of the solvent, and optional treatment of the dried layer at elevated temperature.

The suspensions described by WO 2015/085441 A1 and WO 2016/128133 A1 are suitable to be directly applied on an electrode, such as an indium-tin-oxide electrode or an active layer comprising a fullerene-based compound (acceptor) and a second active material (donor). However, because of the solvent polarity, said suspensions damage sensitive active layers, (e.g. perovskite active layers, small organic molecules active layers, organic polymers active layers, organic light emitting layers, quantum dots active layers), when applied either directly on such active layer or on an additional organic intermediate layer present on such active layer through which typically the polar solvent diffuses. Furthermore, the rather high solvent polarity is also disadvantageous for good substrate wettability and homogeneous dry film formation in case the layer to be coated is a hydrophobic organic charge transport layer, such as e.g. crosslinked PEDOT:PSS.

For sensitive perovskite active layers, WO 2015/085441 A1 proposes the use of an intermediate fullerene-based layer to prevent corrosion of the active layers.

Lu et al (Journal of Materials Research and Technology, Vol 24, May-June 2023, Pages 8162-8170) describes an inorganic/organic composite hole transport bilayer as buffer layer for carbon electrode perovskite solar cells. The inorganic layer is a NiOx layer obtained by applying a suspension of NiOx in isopropanol to the organic hole transport layer. Lu et al proposes the use of a charge selective polythiophene (P3HT) as an organic hole transport layer between the perovskite layer and the NiOx layer to avoid corrosion by carbon paste, inhibit moisture infiltration and promoting effective charge transport and extraction of holes to the anode. The NiOx suspensions in isopropanol used by Lu et al suffer from poor colloidal shelf-life stability and thus, are not suitable for high volume manufacturing with sufficient quality reproducibility. Further, because of the solvent polarity they cannot be directly applied on the active layer (e.g. perovskite layer), and require the use of an intermediate layer such as P3HT to prevent solvent induced corrosion of said layer by the suspension. Also because of the solvent polarity, such NiOx suspensions in isopropanol are incompatible with hydrophobic organic charge transport layers (e.g. crosslinked PEDOT:PSS) resulting in an inhomogeneous charge transport layer when applied on such layers.

Hence, there is a need for colloidally stable metal oxide nanoparticle suspensions for the production of charge transport layers that do not damage active layers that are sensitive to polar solvents (e.g. perovskite active layers, small organic molecules active layers, organic polymers active layers, organic light emitting layers, quantum dots active layers) when applied on such layers (either directly on such layers or on an intermediate organic charge transport layer that may be arranged between the metal oxide charge transport layer and the active layer), and ensure good wettability and homogeneous film formation if applied on an intermediate hydrophobic organic charge transport layer separating the sensitive active layer from the metal oxide charge transport layer. There is also a need for high performing optoelectronic devices containing metal oxide charge transport layers compatible with sensitive active layers, e.g. perovskite active layers, small organic molecules active layers, organic polymers active layers, organic light emitting layers, quantum dots active layers, that can be produced by manufacturing processes meeting the industrial manufacturing requirements, e.g. by non-including vapor phase processes or precursor-based layers requiring high annealing temperatures.

### SUMMARY OF THE INVENTION

Accordingly, it is an object of the present invention to provide an optoelectronic device comprising a multitude of layers, wherein at least one of said multitude of layers is a charge transport layer comprising metal oxide nanoparticles and a zwitterionic ligand.

Also claimed and described herein is a suspension for the production of the charge transport layer of the optoelectronic device. Said suspension comprises
(a) from about 0.1 wt-% to about 40 wt-% of metal oxide nanoparticles;
(b) from about 1 wt-% to about 200 wt-% of a zwitterionic dispersant based on the amount of the metal oxide nanoparticles; and
(c) up to 99.899 wt-% of a solvent having a dielectric constant at 20 °C lower than 10.

Also claimed and described herein a process for manufacturing the optoelectronic device.

### DETAILED DESCRIPTION OF THE INVENTION

Thus, it is an object according to the present invention to address the need for high performing optoelectronic devices containing metal oxide charge transport layers compatible with sensitive active layers, e.g. perovskite active layers, small organic molecules active layers, organic polymers active layers, organic light emitting layers, quantum dots active layers, that can be produced by manufacturing processes meeting the industrial manufacturing requirements, e.g. by non-including vapor phase processes or processes requiring high annealing temperatures. The object is achieved by the optoelectronic device according to claim 1, the suspension for producing the metal oxide charge transport layers present in said optoelectronic device according to claim 9, and the manufacturing process according to claim 13. Preferred embodiments are disclosed in the specification and the dependent claims.

The present invention will be described in more detail below.

Where the present description refers to "preferred" embodiments/features, combinations of these "preferred" embodiments/features are also deemed to be disclosed as long as the specific combination of the "preferred" embodiments/features is technically meaningful.

Unless otherwise stated, the following definitions shall apply in this specification:
As used herein, the term "a", "an", "the" and similar terms used in the context of the present invention (especially in the context of the claims) are to be construed to cover both the singular and plural unless otherwise indicated herein or clearly contradicted by the context.

As used herein, the term "and/or" means that either all or only one of the elements of said group may be present. For example, "A and/or B" means "only A, or only B, or both A and B". In the case of "only A", the term also covers the possibility that B is absent, i.e. "only A, but not B".

As used herein, the terms "including", "containing" and "comprising" are used herein in their open-ended, nonlimiting sense. It is understood that the various embodiments, preferences and ranges may be combined at will. Thus, for instance a solution comprising a compound A may include other compounds besides A. However, the term "comprising" also covers, as a particular embodiment thereof, the more restrictive meanings of "consisting essentially of" and "consisting of, so that for instance "a solution comprising A, B and optionally C" may also (essentially) consist of A and B, or (essentially) consist of A, B and C. As used herein, the transitional phrase "consisting essentially of" (and grammatical variants) is to be interpreted as encompassing the recited materials or steps and those that do not materially affect the basic and novel characteristic(s) of the claimed invention. Thus, the term "consisting essentially of" should not be interpreted as equivalent of "comprising".

As used herein, the term "about" means that the amount or value in question may be the specific value designated or some other value in its neighborhood. Generally, the term "about" denoting a certain value is intended to denote a range within ± 5 % of the value. As one example, the phrase "about 100" denotes a range of 100 ± 5, i.e. the range from 95 to 105. Preferably, the range denoted by the term "about" denotes a range within ± 3 % of the value, more preferably ± 1 %. Generally, when the term "about" is used, it can be expected that similar results or effects according to the invention can be obtained within a range of ±5 % of the indicated value.

The term "optoelectronic device" is known in the field and denotes electronic devices that source, detect or control light. Accordingly, such devices either convert an electrical signal into an optical signal (light emitting devices such as displays) or vice versa (light absorbing devices, such as optical sensors and solar cells).

The terms "Perovskite PV", "OPV", "OLED", "QD-LED" are known in the field and relate to optoelectronic devices comprising a "substrate" and a multitude of layers, wherein at least one layer is a "charge transport layer" as defined herein. In such devices at least one layer is an "active layer", being responsible for either converting light into electric energy or converting electric energy into light. Depending on the remaining layers, its structure and connection, these devices serve a multitude of purposes, such as a perovskite solar cell ("Perovskite PV"), organic solar cell ("OPV"), organic light emitting diode ("OLED"), quantum dot light emitting diode ("QD-LED") or an organic photo detector.

The terms "charge transport layer", "buffer layer", are used interchangeably and denote an interface layer in optoelectronic devices. Charge transport layer is the general term for layers with a charge selective function, such as hole transport (HTL) or electron transport (ETL). In the context of the present invention the term charge transport layer is generally representing the different specific functions. Accordingly, the term charge transport layer includes both, electron transport layers and hole transport layers. The term charge transport layer includes the terms hole extraction layer (HEL), hole injection layer (HIL), electron extraction layer (EEL) and electron injection layer (EIL).

The term "active layer" denotes a layer which is photoactive and either converts light into electrical energy (light absorbing; e.g. solar cells) or converts electrical energy into light (light emitting; e.g. LED's). The active layer of "OPV", "OLED" and organic photodetectors comprises polymers or small molecules, the active layer of "QD-LEDs" comprises quantum dots and the active layer of perovskite solar cells comprises perovskite crystals.

The terms "perovskite" and "perovskite-type materials" are known in the field and generally relate to crystalline materials complying with structure ^{XII}A^{VI}BX₃. Perovskite-type materials for example include metal organic halide materials such as methyl-ammonium-lead-iodide (CH₃NH₃PbI₃) or methyl-ammonium-tin-iodide (CH₃NH₃SnI₃).

The term "perovskite crystals" is known and particularly includes crystalline compounds of the perovskite structure. Such perovskite structures are known per se and described as cubic, pseudocubic, tetragonal or orthorhombic crystals of general formula M1M2X3, where M1 are cations of coordination number 12 (cuboctaeder) and M2 are cations of coordination number 6 (octaeder) and X are anions in cubic, pseudocubic, tetragonal or orthorhombic positions of the lattice. In these structures, selected cations or anions may be replaced by other ions (stochastic or regularly up to 30 atom-%), thereby resulting in doped perovskites or non-stochiometric perovskites, still maintaining its original crystalline structure.

The term "nanoparticle" is known in the field and particularly relates to solid amorphous or crystalline particles having at least one dimension in the size range of 1 - 100 nm. Preferably, nanoparticles are approximately isometric (such as spherical or cubic nanoparticles). Particles are considered approximately isometric, in case the aspect ratio (longest : shortest direction) of all 3 orthogonal dimensions is 1 - 2. In an advantageous embodiment, the nanoparticles have an average primary particle diameter of 2 - 40 nm, preferably 4 - 20 nm (measured by transmission electron microscopy).

The term "metal oxide nanoparticles" includes (i) nanoparticles of pure oxides, (ii) nanoparticles of doped oxides, (iii) mixed metal oxides.

The terms "surfactant", "ligand", "dispersant" and "dispersing agent" are known in the field and have essentially the same meaning and denote an organic substance, other than a solvent, which is used in suspensions or colloids to improve the separation of particles and to prevent agglomeration or settling. Without being bound to theory, it is believed that surfactants are physically or chemically attached on the particle surface either before or after adding the particles to the solvent and thereby provide the desired effects.

The term "suspension" is known and relates to a heterogeneous fluid of an internal phase (i.p.) that is a solid and an external phase (e.p.) that is a liquid. The external phase comprises one or more dispersants/surfactants, optionally one or more solvents and optionally one or more pre-polymers.

Surprisingly, it has been found that an optoelectronic device comprising a multitude of layers with at least one of said multitude of layers being a charge transport layer comprising metal oxide nanoparticles and a zwitterionic ligand exhibits excellent efficiency and/or life-time and can be reliably produced in a cost-efficient manner at industrial scale. Specifically, the manufacturing process relies exclusively on solution-processes and does not involve use of vapor phase processes, and additionally does not require post-treatment (e.g. plasma cleaning or annealing temperatures > 150°C) . The charge transport layer comprising metal oxide nanoparticles and a zwitterionic ligand, wherein preferably said nanoparticles are coated with said zwitterionic ligand, is fully compatible with the other layers present in the optoelectronic devices (i.e. does not degrade the other layers present in the optoelectronic device during the manufacturing process and does not negatively impact their properties during the lifetime of the optoelectronic device), and ensures good electronic energy level alignment between the adjacent layers, such as electrode, active layer or intermediate charge transport layer. The claimed optoelectronic devices having a zwitterionic ligand in the charge transport layer exhibit significantly higher efficiency (e.g. power conversion efficiency) compared to optoelectronic devices containing a cationic or anionic ligand instead of the zwitterionic ligand.

The optoelectronic device is preferably a light absorbing optoelectronic device, more preferably a solar cell, in particular a perovskite solar cell. The active layer present in the solar cell may comprise or consists of organic small molecules, organic polymer, or perovskite crystals, in particular perovskite crystals.

Typically a solar cell comprises a photoconversion layer (active layer) that is arranged between a first electrode and a second electrode. The first and the second electrodes are in electrical contact with the photoconversion layer. This means that they are directly or indirectly electrically connected with the photoconversion layer. Directly in contact means that the electrode touches directly the photoconversion layer. Indirectly in contact means that there might be one or more charge transport layers between the electrode and the photoconversion layer, in particular a hole or an electron charge transport layer. Advantageously, there might be a partial contact between the first and the second electrode with the photoconversion layer, e.g. if the charge transport layer is porous.

A preferred embodiment according to the present invention is directed to a solar cell, in particular a perovskite solar cell, wherein one or more of the herein described charge transport layers comprising the metal oxide nanoparticles and the zwitterionic ligand are arranged between the first electrode and the active layer and/or between the second electrode and the active layer. If the solar cell, in particular the perovskite solar cell, contains at least two of the charge transport layers described herein, said layers have a different composition. The charge transport layer described herein exhibits advantageous energy level alignment with the active layer. Besides the herein described charge transport layers, the solar cell, in particular the perovskite solar cell, may contain one or more of an additional charge transport layer (i.e. charge transport layers other than the charge transport layer comprising the metal oxide nanoparticles and the zwitterionic ligand) arranged between the first electrode and the active layer and/or the second electrode and the active layer. In preferred embodiments, such an additional charge transport layer is arranged between the charge transport layer described herein comprising the metal oxide nanoparticles and the zwitterionic ligand and the active layer.

The solar cell may contain charge transport layers arranged between the first electrode and the photoconversion layer and between the second electrode and the photoconversion layer. Advantageously, in such architecture either the charge transport layers arranged between the first electrode and the photoconversion layer are hole transport layers and the charge transport layers arranged between the second electrode and the photoconversion layer are electron transport layers, or the charge transport layers arranged between the first electrode and the photoconversion layer are electron transport layers and the charge transport layers arranged between the second electrode and the photoconversion layer are hole transport layers.

If two charge transport layers are present between an electrode and the photoconversion layer then the charge transport layer being in direct contact with the photoconversion layer is called "intermediate charge transport layer". If two electron transport layers are present between an electrode and the photoconversion layer then the electron transport layer being in direct contact with the photoconversion layer is called "intermediate electron transport layer". If two hole transport layers are present between an electrode and the photoconversion layer then the hole transport layer being in direct contact with the photoconversion layer is called "intermediate hole transport layer".

The additional charge transport layers described herein may be organic layers (e.g. organic small molecules or polymers) or inorganic layers (e.g. known metal oxides layers).

Examples of additional organic charge transport layers include, but are not limited to poly(3,4-ethylenedioxythiophene):poly(styrensulfonate) (PEDOT:PSS), poly[(4,4'-bis(2-butyloctoxycarbonyl-[2,2'-bithiophene]-5,5-diyl)-alt-(2,2'-bithiophene-5,5'-diyl)] (PDCBT), poly(3-hexylthiophen-2,5-diyl) (P3HT), and N4,N4'-di(naphthalen-1-yl)-N4,N4'-bis(4-vinylphenyl)biphenyl-4,4'-diamine (VNPB).

The first electrode and/or the second electrode may be an indium tin oxide (ITO) electrode, a fluorine tin oxide (FTO) electrode, a carbon electrode, a gold electrode, a silver electrode, a PEDOT:PSS electrode and silver nanowires, preferably ITO or FTO.

In one preferred embodiment, the optoelectronic device is a perovskite solar cell. The perovskite crystals of the active layer preferably form a polycrystalline layer, in particular a polycrystalline layer having a thickness of 0.3-5µm.

As the charge transport layer described herein is fully compatible with perovskite (i.e. does not degrade the perovskite active layer present in the solar cell during the manufacturing process and does not negatively impact its properties during the lifetime of the solar cell), it may be advantageously arranged above the perovskite active layer, either in direct contact with the perovskite active layer or on top of an intermediate organic charge transport layer. Thus, a preferred embodiment according to the present invention is directed to a perovskite solar cell, wherein the charge transport layer is arranged either adjacent to a perovskite layer, or adjacent to an intermediate, preferably hydrophobic, organic charge transport layer, wherein said intermediate organic charge transport layer is arranged between the charge transport layer and the active layer.

The intermediate organic charge transport layer is preferably an organic hole transport layer, preferably selected from PEDOT:PSS, most preferably crosslinked PEDOT:PSS.

A first layer being arranged adjacent to a second layer means that the first layer is in direct contact with the second layer. The surface of the first layer may fully or partially overlap with the surface of the second layer.

Further it is preferred that the charge transport layer is arranged adjacent to an electrode, preferably a carbon electrode, in the perovskite solar cell.

The perovskite solar cell may have the following architecture:
- first electrode/ electron transport layer /perovskite layer / hole transport layer / second electrode, wherein at least one of the electron transport layer and the hole transport layer comprises metal oxide nanoparticles and the zwitterionic ligand;
- first electrode/ hole transport layer /perovskite layer / electron transport layer / second electrode, wherein at least one of the electron transport layer and the hole transport layer comprises metal oxide nanoparticles and the zwitterionic ligand;
- first electrode/ electron transport layer /perovskite / intermediate hole transport layer / hole transport layer / second electrode, wherein at least one of the electron transport layer, the intermediate hole transport layer and the hole transport layer comprises metal oxide nanoparticles and the zwitterionic ligand;
- first electrode/ electron transport layer / intermediate electron transport layer / perovskite layer / hole transport layer / second electrode, wherein at least one of the electron transport layer, the intermediate electron transport layer and the hole transport layer comprises metal oxide nanoparticles and the zwitterionic ligand;
- first electrode/ electron transport layer / intermediate electron transport layer /perovskite layer / intermediate hole transport layer / hole transport layer / second electrode, wherein at least one of the electron transport layer, the intermediate electron transport layer, the intermediate hole transport layer and the hole transport layer comprises metal oxide nanoparticles and the zwitterionic ligand.

In the above architectures, the charge transport layer comprising the metal oxide nanoparticles and the zwitterionic ligand is formed on the perovskite layer i.e. is applied either directly on the perovskite layer or on an intermediate charge transport layer, in particular an organic, preferably hydrophobic, charge transport layer.

In one embodiment, the perovskite solar cell contains an intermediate electron transport layer and/or an intermediate hole transport layer, whereby said intermediate electron transport layer and/or said intermediate hole transport layer comprises the metal oxide nanoparticles and the zwitterionic ligand.

In a further embodiment, the perovskite solar cell contains an intermediate hole transport layer selected from PEDOT:PSS and a hole transport layer comprising the metal oxide nanoparticles and the zwitterionic ligand, preferably selected from nickel oxide or antimony doped tin oxide.

In a further embodiment, the perovskite solar cell comprises a titanium oxide intermediate electron transport layer and an electron transport layer comprising the metal oxide nanoparticles and the zwitterionic ligand, preferably selected from tin oxide, titanium oxide or antimony doped tin oxide.

The perovskite solar cell may be a transparent or semi-transparent perovskite solar cell, whereby the first and the second electrode is transmissive to light.

The terms "zwitterionic surfactants", "zwitterionic ligands", "zwitterionic dispersants" and "zwitterionic dispersing agents" are used interchangeably and refer to amphoteric surfactants, which is a class of compounds well known in the art. These compounds consist of a cationic part and an anionic part. In the zwitterionic ligand described herein,
- the cationic part is preferably selected from an ammonium group, a sulfonium group, and a phosphonium group, and more preferably is an ammonium group; and
- the anionic part is preferably selected from a carboxylate group, a sulfonate group, a sulfite group, a sulfate group, a phosphinate group, a phosphonate group, a phosphite group and a phosphate group, more preferably from a carboxylate group, a sulfonate group and a phosphonate group.

Examples of zwitterionic ligands include, but are not limited to betaines, such as caprylic glycinate, cocamidopropylbetain, and disodium cocoampho diacetate; 3-(N,N-dimethylalkylammonio)propane sulfonate, alkylphospoazanium zwitterion, and phosphocholine.

Specific groups of zwitterionic surfactants include:
- Ammonium carboxylates of formula (I-1),
- Ammonium derivatives of formula (I-2),
- Phosphocholines of formula (I-3),
- 1-Ammonium-2-propanol derivatives of formula (I-4),
- Amidoalkyl ammonium carboxylates of formula (I-5),
- Amidoalkyl ammonium derivatives of formula (I-6), and
- 1-(Amidoalkyl-ammonium)-2-hydroxy-propyl derivatives of formula (I-7).
Ammonium carboxylates of formula (I-1), 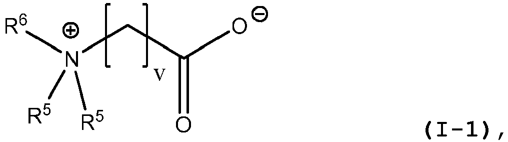 wherein:
R⁵ is H or methyl,
v is 1-8, and
R⁶ is an non-polar tail, selected from substituted or unsubstituted hydrocarbons.
R⁶ is preferably selected from the group of alkyl, alkoxy-alkyl, aryl-alkyl, aryloxy-alkyl, and alkenyl.
R⁶ is particularly preferably selected from linear or branched alkyl, more preferably a linear or branched C₈₋₃₀ alkyl, most preferably C₁₀₋₂₀alkyl.
v preferably represent an integer from 1-4.

Specific subgroups of ammonium carboxylates (I-1) include glycinates where R⁵ is H and v is 1, dimethyl ammonium betaines where R⁵ is CH₃ and v is 1, and ammonium propionates where R⁵ is H and v is 2).

Ammonium derivatives according of formula (I-2), 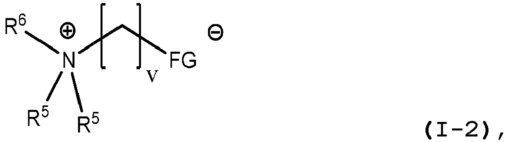 wherein:
R⁵, R⁶ and v are as defined in formula (I-1), and
FG represents a negatively charged functional group.

FG is preferably selected from the group consisting of sulfonate (end group -SO₃⁻), sulfite (end group O-SO₂⁻), sulfate (end group -O-SO₃⁻), phosphonate (end group -P(OR⁷)O₂⁻), phosphinate (end group -PR⁷O₂⁻), phosphate (end group -O-P(OH)O₂⁻) and phosphite (end group -O-P(H)O₂⁻).

R⁷ is preferably selected from the group of alkyl, alkoxy-alkyl, aryl-alkyl-, aryloxy-alkyl-, and alkenyl.

R⁷ is particularly preferably selected from linear or branched alkyl, more preferably a linear or branched C₈₋₃₀ alkyl, most preferably C₁₀₋₂₀alkyl.

A preferred subgroup are ammonium sulfonates of formula (I-2.1), 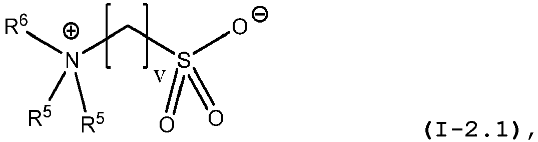 wherein:
R⁵, R⁶ and v are as defined in formula (1-2).

Specific subgroups of ammonium sulfonates according to formula (I-2.1) include sulfobetaines wherein R⁵ is CH₃).

A further preferred subgroup are ammonium sulfites of formula (I-2.2), 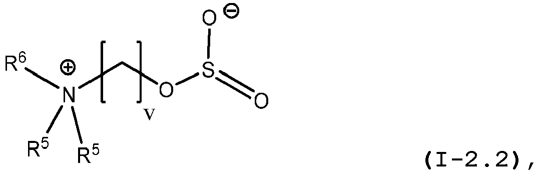 wherein:
R⁵, R⁶ and v are as defined in formula (1-2).

Specific subgroups of ammonium sulfites of formula (I-2.2) include sulfitobetaines wherein R⁵ is CH₃.

A further preferred subgroup are ammonium sulfates according to formula (I-2.3), 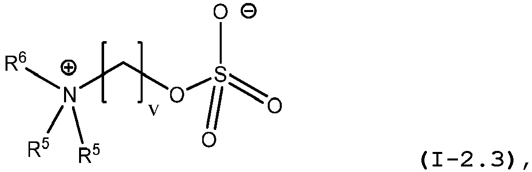 wherein:
R⁵, R⁶ and v are as defined in formula (1-2).

Specific subgroups of ammonium sulfates of formula (I-2.3) include sulfatobetaines wherein R⁵ = CH₃.

A further preferred subgroup are ammonium phosphonates according to formula (I-2.4), 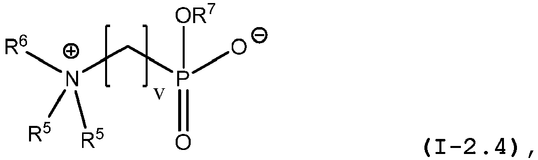 wherein:
R⁵, R⁶, R⁷ and v are as defined in formula (I-2), and

Specific subgroups of ammonium phosphonates of formula (I-2.4) include phosphonatebetaines where R⁵ is CH₃.

A further preferred subgroup are ammonium phosphinates according to formula (I-2.5), 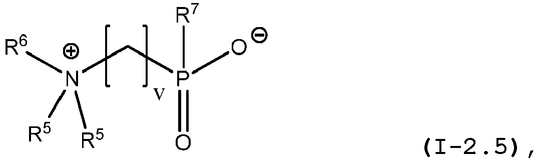 wherein:
R⁵, R⁶, R⁷ and v are as defined in formula (I-2).

Specific subgroups of ammonium phosphinates according to formula (I-2.5) include phosphinatebetaines where R⁵ = CH₃.

A further preferred subgroup are ammonium phosphates according to formula (I-2.6), 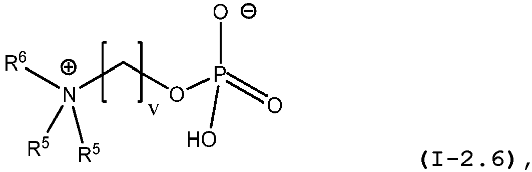 wherein:
R⁵, R⁶ and v are as defined in formula (1-2).

Specific subgroups of ammonium phosphates according to formula (I-2.6) include phosphatobetaines where R⁵ = CH₃.

A further preferred subgroup are ammonium phosphites according to formula (I-2.7), 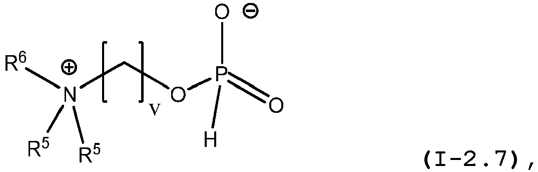 wherein:
R⁵, R⁶ and v are as defined in formula (1-2).

Specific subgroups of ammonium phosphites according to formula (I-2.7) include phosphitobetaines where R⁵ = CH₃.

Phosphocholine derivatives according to formula (I-3), 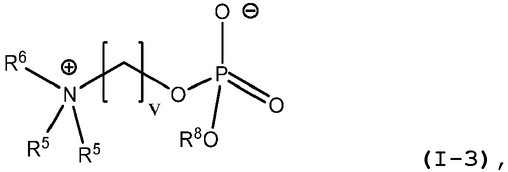 wherein:
v is 1-8, preferably 1-4, particular preferably 2,
R⁵ and R⁶ are independently of each other selected from hydrogen and methyl, and
R⁸ is a non-polar tail selected from substituted or unsubstituted hydrocarbons.

R⁸ is preferably selected from the group of alkyl, alkoxy-alkyl (e.g. (poly)ethoxy-alkyl, such as ethoxy-alkyl, di(ethoxy)alkyl, tri(ethoxy)alkyl etc; (poly)propoxy-alkyl, such as propoxy-alkyl, di(propoxy)alkyl, tri(propoxy)alkyl), aryl-alkyl-, aryloxy-alkyl-, and alkenyl.

R⁸ is particularly preferably selected from linear or branched alkyl, more preferably a linear or branched C₈₋₃₀ alkyl, most preferably C₁₀₋₂₀alkyl.

Specific subgroups of phosphocholines according to formula (I-3) include phosphitobetaines where R⁵ and R⁶ are CH₃. A specific example is miltefosine.

1-Ammonium-2-propanol-derivatives of formula (I-4), 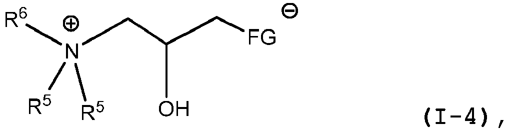 wherein:
R⁵ and R⁶ are as defined in formula (I-1), and
FG represents a negatively charged functional group.

FG preferably is selected from the group consisting of sulfonate (end group -SO₃⁻), sulfite (end group O-SO₂⁻), sulfate (end group -O-SO₃⁻), phosphonate (end group-P(OR⁷)O₂⁻), phosphinate (end group -PR⁷O₂⁻), phosphate (end group -O-P(OH)O₂⁻) and phosphite (end group -O-P(H)O₂⁻) wherein R⁷ is defined above.

FG particularly preferably represents sulfonate. Specific subgroups of compounds of formula (V-4) include hydroxyl sulfobetaines where R⁵ and R⁶ is CH₃ and FG is -SO₃⁻.

Amidoalkyl ammonium carboxylates of formula (I-5), 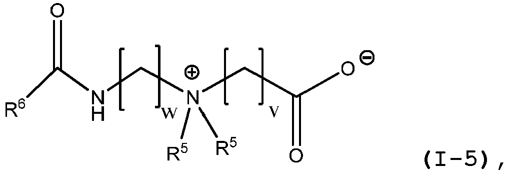 wherein:
R⁵, R⁶, and v are as defined in formula (I-1), and
w is 2-5, preferably 2.

Amidoalkyl ammonium derivatives of formula (I-6), 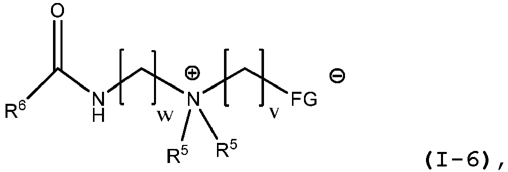 wherein:
R⁵, R⁶, and v are as defined in formula (I-1),
w is 2-5, preferably 2, and
FG represents a negatively charged functional group.

FG preferably represents a sulfonate (end group -SO₃⁻), sulfites (end group O-SO₂⁻) and sulfates (end group -O-SO₃⁻ ), phosphonates (end group -P(OR⁷)O₂⁻), phosphinates (end group -PR⁷O₂⁻), phosphates (end group -O-P(OH)O₂⁻) and phosphites (end group -O-P(H)O₂⁻) and wherein R⁷ is defined above.

FG particularly preferably represents a sulfonate. Specific subgroups of amidoalkyl ammonium sulfonates include amido alkyl sulfobetaines where R⁵ is CH₃ and FG is -SO₃⁻ .

1-(Amidoalkyl-ammonium)-2-hydroxy-propyl derivatives according to formula (I-7) 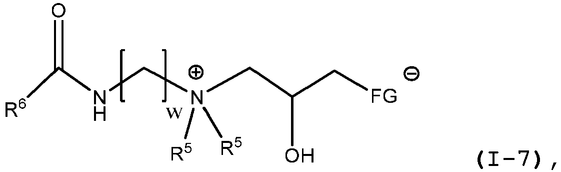 wherein:
R⁵ and R⁶ are as defined in formula (I-1), and
FG represents a negatively charged functional group.

FG particularly preferably represents a sulfonate. Specific subgroups of amidoalkyl hydroxy ammonium sulfonates include amidoalkyl hydroxyl sulfobetaines where R⁵ is CH₃ and FG is -SO₃⁻.

Imidazoline-derived amphoteric surfactants: This group includes amphoacetates (mono or diacetates) and amphopropionates.

In a preferred embodiment, the zwitterionic ligand is a phosphocholine as defined herein.

The term metal oxide nanoparticles is defined above. The metal oxide nanoparticles are preferably selected from the group consisting of pure metal oxides, mixed metal oxides, and doped metal oxides.

In one embodiment, the nanoparticles are selected from the group consisting of pure metal oxides, preferably ZnO, SnOx, TiOx, NiOx, WOx.

In one embodiment, the nanoparticles are selected from the group consisting of mixed metal oxides, preferably zinc containing mixed metal oxides, most preferably indium gallium zinc oxide (IGZO), indium zinc oxide (IZO), zinc tin oxide (ZnSnO₃), zinc magnesium oxide (ZnMgxOy).

In one embodiment, the nanoparticles are selected from the group consisting of doped metal oxides, particularly doped ZnO, SnOx, TiOx, NiOx, WOx, most preferably SnOx and NiOx. Suitable dopants and amounts of dopants are known in the field. The term doped metal oxide relates to compositions of MOₓ where Metal (M) is substituted by one or more metals (="dopants"). The dopant atoms are incorporated into the M_{Y}Oₓ crystal lattice either substitutionally or interstitially forming a homogeneous single-phase (a "solid solution"). Specific examples include ITO (indium tin oxide; typical 90% In₃O₃: 10% SnO₂) und ATO (antimony doped tin oxide; typical 90% SnO₂: 10% Sb₃O₃). In the context of the present invention, separated multiphase systems (e.g. MOₓ + Fe₃O₃) are not considered doped oxides. Doping of oxides can enable the fine tuning of the properties of the inventive thin films, such as electrical conductivity, work function and / or optical absorbance. The metal oxides may be doped with 0.001 - 30 wt%, preferably 0.01 - 15 wt%, most preferably 0.1 - 10 wt% (with respect to the metal), by one or more metals. In a preferred embodiment, said dopant atoms are selected from the group consisting of transition metals, alkaline metals and earth-alkaline metals.

A preferred embodiment according to the invention pertains to an optoelectronic device as claimed and described herein, wherein said metal oxides nanoparticles are selected from nickel oxide, doped nickel oxide, particularly copper doped nickel oxide, zinc oxide, doped zinc oxide, particularly aluminum doped zinc oxide, tin oxide, doped tin oxide, particularly antimony doped tin oxide, titanium oxide, and doped titanium oxide nanoparticles, preferably from nickel oxide, doped nickel oxide, particularly copper doped nickel oxide, tin oxide, and doped tin oxide, particularly antimony doped tin oxide nanoparticles.

The metal oxide nanoparticles of the charge transport layer are preferably coated with the zwitterionic ligand. Without being bound to theory, it is believed that the coating of the nanoparticles by the zwitterionic ligand has a beneficial effect on the electronic properties of corresponding charge transport layer. As used herein, the term coating includes (i) direct chemical bonding (e.g. a covalent bond) between the metal oxides as defined herein and the ligand as defined herein and (ii) adsorption of the dispersant on the surface of the metal oxides (e.g. physisorption). An equilibrium between chemical bonding/adsorption and free components may exist, depending on the metal oxide and the dispersant.

The charge transport layer preferably consists of metal oxide nanoparticles and the herein described ligand.

In one embodiment, said metal oxide nanoparticles are coated with one type of ligands as defined herein. In a further embodiment, the invention provides a charge transport layer with the following composition: 34 - 99 wt-% metal oxide and 1 - 66 wt-% zwitterionic ligand, preferably 50 - 97 wt-% metal oxide and 3 - 50 wt-% zwitterionic ligand, more preferably 67 - 94 wt-% metal oxide and 6 - 33 wt-% zwitterionic ligand, most preferably 75 - 90 wt-% metal oxide and 10 - 25 wt-% zwitterionic ligand, the wt-% being based on the total weight of the charge transport layer.

In advantageous embodiments, the charge transport layer is an electron transport layer consisting of the zwitterionic ligand and zinc oxide nanoparticles, doped zinc oxide nanoparticles, mixed zinc oxide nanoparticles, tin oxide nanoparticles, doped tin oxide nanoparticles, mixed tin oxide nanoparticles, titanium oxide nanoparticles, doped titanium oxide nanoparticles, or mixed titanium oxide nanoparticles.

In further advantageous embodiments the charge transport layer is a hole transport layer consisting of the zwitterionic agent and nickel oxide nanoparticles, tungsten oxide nanoparticles, or antimony doped tin oxide (ATO) nanoparticles, in particular antimony doped tin oxide nanoparticles, preferably containing 5-30mol-%, preferably 10 - 20 mol-% antimony with respect to the total metal oxide composition.

The charge transport layer preferably has a layer thickness of 2 - 200 nm, preferably 4 - 100 nm, most preferably 10 - 50 nm. In one embodiment, monolayers, typically 2-50 nm, preferably 4 - 20 nm thick are also envisaged. Thickness may be determined by profilometry, atomic force microscopy or transmission electron microscopy.

The charge transport layer may be dense, mesoporous or nanoparticulate.

The charge transport layers may have a mean surface roughness below 20 nm, especially below 10 nm (determined by electron microscopy, atomic force microscopy or profilometry).

Preferably, the charge transport layer described herein is
- uniform (i.e. has a constant thickness all over it surface) and
- has a mean surface roughness below 20 nm.

A second aspect according to the invention is directed to a suspension and the use of said suspension for the production of the charge transport layer described herein. Said suspension comprises
(a) from about 0.1 wt-% to about 40 wt-%, preferably from about 0.5 wt-% to about 30 wt-%, more preferably from about 1 wt-% to about 20 wt-%, of the metal oxide nanoparticles described herein based on the total weight of the suspension;
(b) from about 1 wt-% to about 200 wt-%, preferably from about 5 wt-% to about 100 wt-%, more preferably from about 10 wt-% to about 50 wt-% of the zwitterionic ligand described herein based on the amount of the metal oxide nanoparticles; and
(c) up to 99.899 wt-% of a solvent having a dielectric constant at 20 °C lower than 10, preferably lower than 7, more preferably lower than 4 based on the total weight of the suspension. As used herein, the dielectric constant of the solvent refers to the dielectric constant of said solvent as determined by capacitance measurements at a temperature of 20 °C. The metal oxide nanoparticles in suspension may have a particle volume-based hydrodynamic size D₉₀ of less than 100 nm, preferably less than 50nm, most preferably less than 20nm (measured by dynamic light scattering or centrifugal sedimentation techniques).

Advantageously, the nanoparticles are synthesized by a gas phase pyrolysis process, preferably flame spray synthesis.

The suspension claimed and described herein is stable for at least 3 months and can be directly applied on a variety of layers present in an optoelectronic device, including electrodes, active layer or charge transport layers, such as on perovskite active layers or intermediate organic charge transport layers.

Preferably, the solvent described herein:
- is halogen-free;
- has a boiling point of 70 - 220°C, preferably 80 - 150°C;
- has a viscosity at 25°C of 0.4 - 30 mPas, preferably 0.5 - 15 mPas.

The solvent described herein is preferably selected from hydrocarbons (including linear, branched and cyclic hydro-carbons), aromatic hydrocarbons, ethers (including glycol-ethers), esters, and mixtures thereof, preferably from saturated hydrocarbons, unsaturated hydrocarbons, aromatic hydrocarbons, and mixtures thereof, more preferably, from linear, branched or cyclic C₅₋₁₅ alkanes, aromatic C₆₋₁₂ hydrocarbons, and mixtures thereof.

In one embodiment, the suspension consists of metal oxide nanoparticles, the zwitterionic ligand and the solvent.

A third aspect according to the invention the invention relates to the manufacturing of the inventive suspensions, and optoelectronic devices disclosed herein. This aspect of the invention shall be explained in further detail below.

The manufacturing of suspensions is a known procedure. The functionalization of nanoparticles with ligands is also a known procedure. These procedures may be applied to the starting materials of the inventive suspensions.

In one embodiment, solvent and nanoparticles are combined, for example by mixing or ball milling. To the obtained initial suspension, the ligands are added. Ligand functionalization of the nanoparticles takes place at room temperature or upon heating and mixing.

In one alternative embodiment, solvent and ligands are combined, for example by mixing. To the obtained initial solution, the nanoparticles are added. Ligand functionalization of the nanoparticles takes place at room temperature or upon heating and mixing.

Advantageously, the optoelectronic devices according to the present invention may be obtained by solution processes. This is considered a significant advantage, as it enables manufacturing of all layers by simple technologies applicable to large areas and continuous processing.

In one embodiment, the invention provides for a process for manufacturing the intermediate good described herein, wherein the process comprises the steps:
i) providing a sheet-like substrate carrying at least one layer; and
ii) applying, preferably by coating or printing, the suspension to the sheet-like substrate carrying the at least one layer; and
iii) optionally removing the solvent from the applied suspension and/or treating the applied suspension at elevated temperature.

The sheet-like substrate may be a glass substrate or polymer substrate. The sheet-like substrate carrying at least one layer may have any of the following architectures:
- sheet-like substrate / electrode layer;
- sheet-like substrate / electrode layer / active layer
- sheet-like substrate / electrode layer / active layer / intermediate organic charge transport layer
- sheet-like substrate / electrode layer/ charge transport layer/ active layer
- sheet-like substrate / electrode layer/ charge transport layer/ active layer/ intermediate organic charge transport layer.

Preferably the sheet-like substrate carrying at least one layer has one of the following architectures:
- sheet-like substrate / electrode layer / active layer
- sheet-like substrate / electrode layer / active layer / intermediate organic charge transport layer
- sheet-like substrate / electrode layer/ charge transport layer/ active layer
- sheet-like substrate / electrode layer/ charge transport layer/ active layer/ intermediate organic charge transport layer.

Step i) Application of the suspension: Many processes are known to apply a liquid composition to a substrate to result in a wet thin film; a person skilled in the art is in a position to appropriately select. Suitable are, for example coating, particularly roll-to-roll-, slot-die-, spray-, ultrasonic spray-, dip-, reel-to-reel-, bladecoating; or by printing, particularly ink-jet-, pad-, offset-, gravure-, screen-, intaglio-, sheet-to-sheet-printing. Such processes are generally considered advantageous for large scale production, when compared to vacuum-based processes. Depending on the composition used in step i), this step may be repeated (i.e. may be performed multiple times). This embodiment is considered advantageous in order to fine tune the final film thickness.

Step ii) Drying and film formation: Many processes are known to remove a liquid from a wet thin film of a coated substrate; a person skilled in the art is in a position to appropriately select. Suitable are, for example drying at room temperature or elevated temperature. Drying may take place in air, in a protecting gas, such as nitrogen or argon. Especially suited are gases with low humidity content (e.g. nitrogen, dry air, argon).

Step iii): Temperature cleaning step: A cleaning step in the form of a temperature annealing can optionally be conducted at temperatures below 150 °C. In an advantageous embodiment, the dried nanoparticle film in step iii) is annealed at 80°C - 150°C in air or in a protecting gas.

To further illustrate the invention, the following **examples** are provided. These examples are provided with no intend to limit the scope of the invention.

### Inventive example 1:

### Preparation of a suspension according to the invention

NiOx nanoparticles were made by flame spray pyrolysis according to a similar procedure as in EP3080849B1 having a mean crystallite size of 7nm (as measured by X-ray diffraction; Scherrer method).
10g of the obtained NiOx nanoparticles was mixed with 297g toluene and 3g phosphatidylcholine (CAS-No. 97281-44-2) by ball-milling. The resulting suspension was colloidally stable for at least 1 month only forming very little sediment.

### Manufacturing of a perovskite solar cell according to the invention

A perovskite solar cell was made as following:
A fluorine-tin-oxide (FTO) glass-based electrode was cleaned with deionized water, ethanol, acetone, and IPA respectively for 30 min in an ultrasonic bath. After drying, it was cleaned with plasma for 5 min. An aqueous SnO₂ nanoparticle solution (Alfa Aesar) was used to prepare the ETL. The solution was diluted to 3.0 wt. % SnO₂ and treated in the ultrasonic bath for 10 minutes followed by filtering using a 0.45 µm PTFE filter. The solution was then spin-coated on the ITO-substrate. Next, the film was annealed at 120 °C for 30 minutes to form a nanoparticulate SnO₂ layer.

A methyl ammonium lead iodide (MAPbI3) precursor solution (1.2 M) was then prepared by dissolving methylammonium iodide (MAI) and lead iodide (PbI2) in a mixed solvent solution of DMF and DMSO (volume ratio of 9:1). This precursor solution was subsequently deposited onto the SnO₂ layer at 4000 rpm for 30 s. The films were then annealed for 20 min at 100°C.

Toluene-based PEDOT:PSS (HTL-Solar-3 from Ossila) with 5 wt% crosslinking agent ((3-glycidyloxypropyl) trimethoxysilane from Sigma Aldrich) was spin-coated and dried at 60°C for 5 min.

The NiOx dispersion was spin-coated on top of the crosslinked PEDOT:PSS layer and dried at 60°C for 5 min.

The resulting NiOx nanoparticle layer was covering the PEDOT:PSS layer completely and it was defect-free. The layer had a low RMS (root-mean-square) surface roughness of 3nm (as measured by AFM; 5x5 micron scan) indicating a good wettability and uniform dry layer formation of the NiOx nanoparticle suspension.

A carbon electrode was deposited by blade coating carbon paste (Dyenamo) following by annealing on a hot plate at 120°C for 15 minutes.

The power conversion efficiency (PCE) of the prepared final perovskite solar cell was measured as 19.8%.

### Comparative example 1:

### Preparation of a suspension containing an anionic dispersant

A dispersion in toluene was made with the NiOx nanoparticles described in example 1. 10g of NiOx was combined with 297g toluene and 3g dioctyl sulfosuccinate sodium salt (CAS: 577-11-7). Then the mixture was dispersed by ball-milling as in experiment 1. The resulting suspension was colloidally stable with only very little sediment forming.

### Manufacturing of a perovskite solar cell

A perovskite solar cell was made as described in example 1 with the NiOx described in the present example.

The power conversion efficiency (PCE) of the prepared final perovskite solar cell was measured as 16.5% which is significantly lower than the PCE obtained with the zwitterionic ligand in example 1.

### Comparative example 2:

### Preparation of a suspension containing a cationic dispersant

Same procedure as in comparative example 1 but with didodecylammonium-bromide (CAS: 3282-73-3) as dispersant instead of dioctyl sulfosuccinate sodium salt. The weight ratio NiOx nanoparticle particles : dispersant = 10g : 3g

### Manufacturing of a perovskite solar cell

A perovskite solar cell was made as described in example 1 with the NiOx described in the present example.

The power conversion efficiency (PCE) of the prepared final perovskite solar cell was measured as 17.40 which is significantly lower than the PCE obtained with the zwitterionic ligand in example 1.

### Inventive example 2

A suspension in toluene was made with Al-doped ZnO (AZO) nanopowder which was prepared also to a similar procedure as in EP3080849B1 having a mean crystallite size of 12nm (as measured by X-ray diffraction; Scherrer method). 10g of AZO was combined with 297g toluene and 3g phosphatidylcholine (CAS-No. 97281-44-2) by ball-milling. The resulting suspension was colloidally stable for at least 1 month only forming very little sediment.

### Inventive example 3

A suspension in toluene was made with SnO₂ nanopowder which was prepared also to a similar procedure as in EP3080849B1 having a mean crystallite size of 10nm (as measured by X-ray diffraction; Scherrer method). 10g of SnO₂ was combined with 297g toluene and 3g phosphatidylcholine (CAS-No. 97281-44-2) by ball-milling. The resulting suspension was colloidally stable for at least 1 month only forming very little sediment.

### Inventive example 4

A suspension in toluene was made with antimony doped tin oxide (ATO) nanopowder with 10 mol-% antimony doping content (Sn_{0.9}Sb_{0.1}Oₓ), which was prepared also to a similar procedure as in EP3080849B1 having a mean crystallite size of 10nm (as measured by X-ray diffraction; Scherrer method). 10g of ATO nanopowder was combined with 297g toluene and 3g phosphatidylcholine (CAS-No. 97281-44-2) by ball-milling. The resulting suspension was colloidally stable for at least 1 month only forming very little sediment.

## Claims

1. An optoelectronic device comprising a multitude of layers, wherein at least one of said multitude of layers is a charge transport layer comprising metal oxide nanoparticles and a zwitterionic ligand, wherein preferably said nanoparticles are coated with said zwitterionic ligand.

2. The optoelectronic device according to claim 1, wherein said optoelectronic device is a perovskite solar cell.

3. The optoelectronic device according to claim 2, wherein the charge transport layer is arranged either adjacent to a perovskite layer, or adjacent to an intermediate, preferably hydrophobic, organic charge transport layer, in particular a PEDOT:PSS layer, wherein said intermediate organic charge transport layer is arranged between the charge transport layer and a perovskite layer.

4. The optoelectronic device according to claim 3, wherein the charge transport layer is arranged adjacent to an electrode, preferably a carbon electrode.

5. The optoelectronic device according to claim 2 having one of the following architectures:
- first electrode / electron transport layer / perovskite layer / hole transport layer / second electrode, wherein at least one of the electron transport layer and the hole transport layer comprises the metal oxide nanoparticles and the zwitterionic ligand;
- first electrode / hole transport layer / perovskite layer / electron transport layer / second electrode, wherein at least one of the electron transport layer and the hole transport layer comprises the metal oxide nanoparticles and the zwitterionic ligand;
- first electrode / electron transport layer / perovskite layer / intermediate hole transport layer / hole transport layer / second electrode, wherein at least one of the electron transport layer, the intermediate hole transport layer and the hole transport layer comprises the metal oxide nanoparticles and the zwitterionic ligand;
- first electrode / electron transport layer / intermediate electron transport layer / perovskite layer / hole transport layer / second electrode, wherein at least one of the electron transport layer, the intermediate electron transport layer and the hole transport layer comprises metal oxide nanoparticles and the zwitterionic ligand;
- first electrode / electron transport layer / intermediate electron transport layer / perovskite layer / intermediate hole transport layer / hole transport layer / second electrode, wherein at least one of the electron transport layer, the intermediate electron transport layer, the intermediate hole transport layer and the hole transport layer comprises the metal oxide nanoparticles and the zwitterionic ligand.

6. The optoelectronic device according to any one of claims 1 to 5, wherein
• said zwitterionic ligand contains a cationic part selected from an ammonium group, a sulfonium group, and a phosphonium group, and an anionic part selected from a carboxylate group, a sulfonate group, a sulfite group, a sulfate group, a phosphinate group, a phosphonate group, a phosphite group and a phosphate group; and/or
• said metal oxide nanoparticles are selected from the group consisting of pure metal oxides, mixed metal oxides, and doped metal oxides.

7. The optoelectronic device according to any one of claims 1 to 6, wherein said zwitterionic ligand is a compound of formula (I-3), 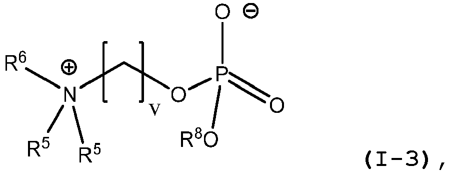 wherein:
v is 1-8, preferably 1-4, particular preferably 2,
R⁵ and R⁶ are independently of each other selected from hydrogen and methyl, and
R⁸ is a non-polar tail selected from substituted or unsubstituted hydrocarbons.

8. The optoelectronic device according to any one of claims 1 to 7, wherein said metal oxides nanoparticles are selected from nickel oxide, doped nickel oxide, particularly copper doped nickel oxide, zinc oxide, doped zinc oxide, particularly aluminum doped zinc oxide, tin oxide, doped tin oxide, particularly antimony doped tin oxide, titanium oxide, and doped titanium oxide nanoparticles.

9. A suspension for the production of the charge transport layer of the optoelectronic device according to any one of claims 1 to 8, wherein said suspension comprises
(a) from about 0.1 wt-% to about 40 wt-% of metal oxide nanoparticles based on the total weight of the suspension;
(b) from about 1 wt-% to about 200 wt-% of a zwitterionic dispersant based on the amount of the metal oxide nanoparticles; and
(c) up to 99.899 wt-% of a solvent having a dielectric constant at 20 °C lower than 10 based on the total weight of the suspension.

10. The suspension according to claim 9, wherein
• said zwitterionic dispersant contains a cationic part selected from an ammonium group, a sulfonium group, and a phosphonium group, and an anionic part selected from a carboxylate group, a sulfonate group, a sulfite group, a sulfate group, a phosphinate group, a phosphonate group, a phosphite group and a phosphate group; and/or
• said metal oxide nanoparticles are selected from the group consisting of pure metal oxides, mixed metal oxides, and doped metal oxides; and/or
• said solvent is selected from hydrocarbons including linear, branched and cyclic hydrocarbons, aromatic hydrocarbons, ethers including glycol-ethers, esters, and mixtures thereof, preferably from saturated hydrocarbons, unsaturated hydrocarbons, aromatic hydrocarbons, and mixtures thereof, more preferably, from linear, branched or cyclic C₅₋₁₅ alkanes, aromatic C₆₋₁₂ hydrocarbons, and mixtures thereof.

11. The suspension according to claim 9 or 10, wherein the zwitterionic dispersant is a compound of formula (I-3), 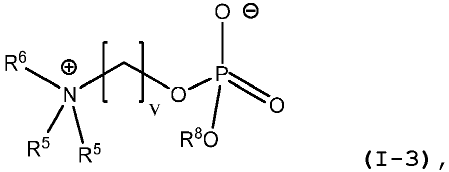 wherein:
v is 1-8, preferably 1-4, more preferably 2,
R⁵ and R⁶ are independently of each other selected from hydrogen and ethyl, and
R⁸ is a non-polar tail selected from substituted or unsubstituted hydrocarbons, preferably from the group of alkyl, alkoxy-alkyl, aryl-alkyl-, aryloxy-alkyl-, and alkenyl.

12. Use of the suspension according to any one of the claims 9 to 11 for manufacturing the charge transport layer contained by the optoelectronic device according to any one of the claims 1 to 8.

13. A process for manufacturing the optoelectronic device according to any one of claims 1 to 8, wherein the process comprises the steps:
i) providing a sheet-like substrate carrying at least one layer; and
ii) applying, preferably by coating or printing, the suspension according to any one of claims 9 to 11 to the sheet-like substrate carrying at least one layer; and
iii) optionally removing the solvent from the applied suspension and/or treating the applied suspension at elevated temperature.
